# FASCICULE DE BREVET EUROPEEN

(11) **EP 0 660 509 B1**
(45) Date de publication et mention de la délivrance du brevet: **21.10.1998**
(21) Numéro de dépôt: 94410110.4
(22) Date de dépôt: 21.12.1994
(51) Int. Cl.: H03F 1/30

(54) **Amplificateur à correction de tension de décalage**
Verstärker mit Offsetgleichspannungskorrektur
Amplifier with offset correction

(30) Priorité: 23.12.1993 FR 9315943
(43) Date de publication de la demande: 28.06.1995
(73) Titulaire: SGS-THOMSON MICROELECTRONICS S.A., 94250 Gentilly (FR)
(72) Inventeur: Jaffard, Jean-Luc, F-38120 Saint Egreve (FR); Fox, Randolph, F-38120 Saint Egreve (FR)
(74) Mandataire: de Beaumont, Michel

(56) Documents cités:
- FR-A- 2 303 413
- FR-A- 2 434 538
- US-A- 3 580 243
- REVIEW OF SCIENTIFIC INSTRUMENTS., vol.59, no.7, Juillet 1988, NEW YORK US pages 1241 - 1243, XP000003610 R.C.S. FREIRE ET AL 'DC AMPLIFIER WITH AUTO-ZEROING OF THERMAL DRIFT'

## Description

La présente invention telle qu'elle est définie dans les revendications concerne un amplificateur muni d'un dispositif permettant de corriger ou ajuster la tension de décalage en sortie de l'amplificateur ou d'un circuit de traitement incluant l'amplificateur. La présente invention concerne plus particulièrement un amplificateur, tel qu'un amplificateur de tête de lecture de bande magnétique, ayant un mode actif où sa sortie est prise en compte par d'autres circuits et un mode inactif où sa sortie est ignorée.

Lorsqu'un signal alternatif doit être traité (amplifié, filtré, etc.), on doit souvent éliminer, à un ou plusieurs points de la chaine de traitement, des composantes continues qui, si elles devenaient trop importantes par des amplifications successives, pourraient entrainer des écrêtements du signal traité. Les composantes continues, ou décalages, sont particulièrement gênantes dans certaines applications, comme le traitement de signaux provenant de têtes de lecture, où elles sont très importantes par rapport à la composante alternative utile du signal à traiter.

Le document US-A-3 580 243 divulgue un dispositif dans lequel les tensions de décalage sont neutralisées.

Pour éliminer une composante continue, on a le plus souvent recours à une capacité que l'on insère dans le trajet du signal traité. Toutefois, si l'on veut transmettre des fréquences basses du signal, comme par exemple dans le traitement du son, ces capacités doivent être choisies de valeur particulièrement élevée, ce qui interdit leur intégration. En outre, dans une chaine de traitement, il est souvent nécessaire d'éliminer des composantes continues en plusieurs points et donc d'insérer plusieurs capacités, ce qui requiert, si le circuit de traitement est intégré, autant de broches supplémentaires à prévoir sur le circuit intégré.

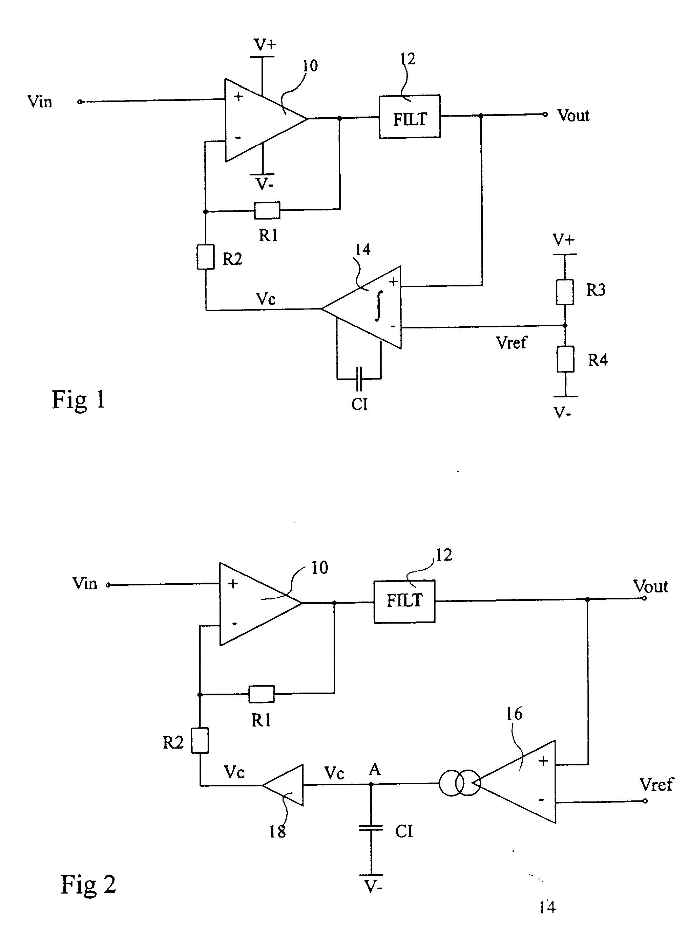

La figure 1 représente un circuit classique permettant d'utiliser une seule capacité pour supprimer la composante continue, ou d'ajuster celle-ci à une valeur voulue, en sortie d'une chaîne de traitement, quels que soient les décalages que subit le signal en amont de cette chaîne.

Dans l'exemple de la figure 1, la chaîne de traitement comprend un amplificateur opérationnel 10 suivi d'un filtre 12 fournissant le signal de sortie Vout de la chaine de traitement. Les éléments du circuit sont alimentés entre une tension haute V+ et une tension basse V-, par exemple la masse. Le signal d'entrée Vin de la chaîne est fourni sur l'entrée non-inverseuse de l'amplificateur 10. L'amplificateur 10 est muni d'une boucle de contre-réaction comprenant une résistance R1 reliée entre sa sortie et son entrée inverseuse et une résistance R2 reliée entre l'entrée inverseuse et une tension de correction ou compensation Vc. La tension de correction Vc est fournie par un intégrateur 14 qui intègre la différence entre la tension de sortie Vout et une tension de référence Vref.

Avec cette configuration, la composante continue de la tension de sortie Vout s'établit à la valeur Vref, et ceci quels que soient les éléments que l'on trouve en amont de la sortie Vout. De préférence, la tension Vref est choisie à mi-chemin entre les tensions d'alimentation V+ et V-, par exemple à l'aide d'un pont de résistances R3, R4 de même valeur. De cette manière, la tension de sortie peut avoir la même amplitude de part et d'autre de sa composante continue, Vref.

Un intégrateur (14) requiert une capacité d'intégration CI qui est généralement connectée entre la sortie et l'entrée inverseuse d'un amplificateur opérationnel. Cette capacité CI, si le signal à traiter peut avoir une fréquence basse (par exemple de 10 Hz dans le domaine du traitement du son), doit être de valeur importante afin d'éviter que la composante continue du signal Vout oscille avec la fréquence basse. Cette capacité n'est alors pas intégrable et il faut prévoir deux broches de connexion supplémentaires sur un circuit intégrant les circuits de traitement pour connecter les deux bornes de la capacité CI.

Un objet de la présente invention est de prévoir un circuit de traitement intégré muni d'une boucle de compensation de décalage qui requiert une seule broche pour connecter une capacité d'intégration externe.

Un autre objet de la présente invention est de prévoir un tel circuit de traitement ayant un mode actif et un mode inactif permettant d'exploiter la capacité d'intégration à des fins de filtrage d'une tension de référence.

La présente invention atteint ces objets grâce à un circuit de traitement comprenant un amplificateur différentiel recevant sur une première entrée un signal à traiter et sur une deuxième entrée un signal de compensation de décalage fourni par un intégrateur de la différence entre la tension de sortie du circuit et une tension de référence sur laquelle on souhaite centrer le signal de sortie. L'intégrateur comprend un amplificateur de transconductance différentiel recevant la tension de sortie sur une première entrée et la tension de référence sur une deuxième entrée ; une capacité dont une première borne est reliée à la sortie de l'amplificateur de transconductance et une deuxième borne reliée à une tension fixe ; et un amplificateur suiveur recevant la tension sur la première borne de la capacité et fournissant le signal de compensation de décalage.

Selon un mode de réalisation de la présente invention, la sortie du circuit de traitement de signal est prise en compte pendant une phase active et ignorée pendant une phase inactive. Le circuit de traitement de signal comprend un premier commutateur commandé pour, dans la phase active, relier la première borne de la capacité à la sortie de l'amplificateur de transconductance et pour, dans la phase inactive, relier la première borne de la capacité à la sortie d'un générateur de la tension de référence.

Selon un mode de réalisation de la présente invention, le circuit de traitement de signal comprend un deuxième commutateur pour, dans la phase active, relier les première et deuxième entrées de l'amplificateur de transconductance au signal de sortie et à la tension de référence, respectivement, et pour, au début de la phase inactive, relier les première et deuxième entrées de l'amplificateur de transconductance à la tension de référenoe et à la sortie de l'amplificateur suiveur respectivement, la commande du premier commutateur étant retardée.

Selon un mode de réalisation de la présente invention, l'amplificateur de transconductance a deux transconductances sélectionnables par un signal de commande qui prend des états tels que la transconductance la plus élevée est sélectionnée au début de chaque transition de mode du circuit de traitement.

Ces objets, caractéristiques et avantages ainsi que d'autres de la présente invention seront exposés en détail dans la description suivante de modes de réalisation particuliers faite à titre non-limitatif à l'aide des figures jointes parmi lesquelles :
la figure 1, précédemment décrite, représente un circuit de traitement de signal classique muni d'une boucle de compensation de tension de décalage ;
la figure 2 représente un circuit de traitement muni d'un mode de réalisation de boucle de compensation de tension de décalage selon l'invention ;
la figure 3 représente un circuit de traitement de signal ayant un mode actif et un mode inactif, muni d'un autre mode de réalisation de boucle de compensation de tension de décalage selon l'invention ;
la figure 4 représente un chronogramme de divers signaux illustrant le fonctionnement de la boucle de compensation de la figure 3 ; et
la figure 5 représente un exemple de circuit permettant d'obtenir des signaux nécessaires au circuit de la figure 3.

La figure 2 représente des mêmes éléments que la figure 1, désignés par des mêmes références. Selon l'invention, on choisit de réaliser l'intégrateur 14 de manière particulière. Cet intégrateur comprend un amplificateur de transconductance 16 recevant sur son entrée non-inverseuse la tension de sortie Vout et sur son entrée inverseuse la tension de référence Vref. L'amplificateur de transconductance 16 fournit à une borne A d'une capacité d'intégration CI un courant sensiblement proportionnel à la différence entre ses tensions d'entrée, Vout et Vref. L'autre borne de la capacité CI est reliée à une tension fixe qui est disponible à l'extérieur du circuit si ce dernier est intégré, comme par exemple la tension d'alimentation basse V-.

Avec cette configuration, la capacité CI se charge d'autant plus vite que la différence entre les tensions Vout et Vref est importante, ce qui correspond bien à une intégration de cette différence.

La tension sur la borne A de la capacité CI correspond à la tension de correction Vc à appliquer sur la résistance R2. Toutefois, pour ne pas charger la sortie de l'amplificateur de transconductance 16, et donc pour ne pas perturber la fonction d'intégration, on place entre la résistance R2 et la borne A un amplificateur suiveur 18.

Le résultat obtenu avec une boucle de compensation selon l'invention est identique à celui de la figure 1. Par contre, la capacité CI comporte une borne qu'il n'est pas nécessaire de relier à l'intérieur du circuit intégré car elle est reliée à l'une des tensions d'alimentation, V- dans l'exemple, qui est disponible à l'extérieur. Par conséquent, le circuit intégré doit comporter une seule broche pour connecter la capacité d'intégration CI.

Parmi les circuits de traitement qui nécessitent une compensation de décalage de tension, il y a des circuits présentant deux modes de fonctionnement, à savoir, un mode actif où la sortie du circuit de traitement est effectivement prise en compte et un mode inactif où la sortie du circuit de traitement est ignorée. Ceci est notamment le cas des amplificateurs de lecture de bande magnétique où, pendant la lecture, on amplifie le signal fourni par une tête de lecture et, pendant l'enregistrement, l'amplificateur de lecture est inutilisé.

Dans un tel circuit, la présente invention prévoit en outre d'utiliser la capacité d'intégration CI pour filtrer, pendant que le circuit de traitement est inactif, une tension de référence nécessaire à d'autres circuits de traitement alors actifs.

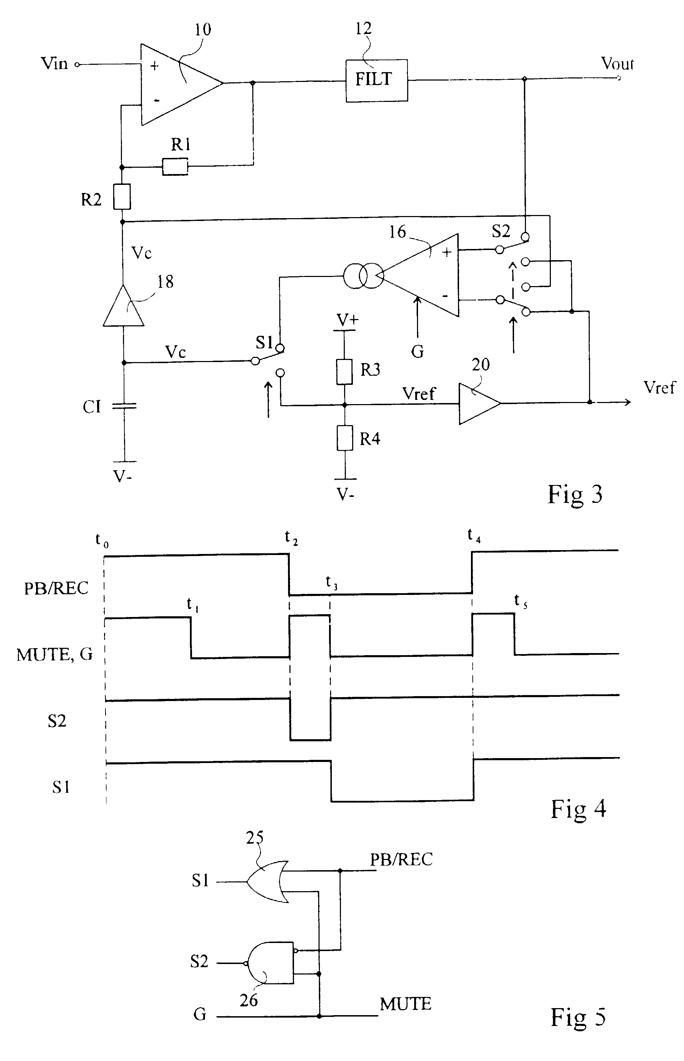

La figure 3 représente un circuit permettant d'obtenir cela selon l'invention. Dans le cas d'un amplificateur de lecture de bande magnétique, la tension de référence Vref sur laquelle on veut ajuster la composante continue de la tension de sortie Vout sert également de référence à des circuits, non représentés, destinés à effectuer l'enregistrement sur bande. Cette tension de référence, obtenue par un pont de résistances R3, R4, suivi d'un amplificateur suiveur 20, est très bruitée et doit être filtrée.

Classiquement, ce filtrage est obtenu en reliant le point de connexion entre les résistances R3 et R4 à l'une des tensions d'alimentation par une capacité de valeur importante qu'il faut bien entendu aussi connecter de manière externe au circuit intégré.

Selon l'invention, on prévoit, grâce à un commutateur S1, de relier la borne A de la capacité d'intégration CI au point de connexion des résistances R3 et R4 pendant la phase inactive du circuit de traitement. Ainsi, la capacité CI sert de capacité d'intégration pendant la phase active et de capacité de filtrage de la tension de référence pendant la phase inactive. On économise ainsi une capacité de filtrage et une broche pour la connecter au circuit intégré. Cet disposition est réalisable sans grande complexité car l'une des bornes de la capacité CI est toujours reliée à un même point, V-.

Le commutateur S1 peut être commandé par l'intermédiaire d'un signal de sélection de mode du circuit de traitement, par exemple le signal (PB/REC) de sélection du mode lecture ou du mode enregistrement dans un magnétophone.

Toutefois, pendant la phase active du circuit de traitement, la capacité CI est chargée à une tension de compensation Vc différente de la tension de référence Vref. Cette différence est d'autant plus importante que le circuit de traitement introduit de décalage de tension. Ainsi, si l'on commute brusquement la borne A de la capacité CI sur le pont de résistances R3, R4, la tension de référence Vref varie brutalement et retrouve progressivement sa valeur initiale. Cette variation brutale se traduirait, dans le cas d'un magnétophone, par l'enregistrement d'une impulsion parasite sur la bande magnétique.

Pour éviter cet inconvénient, la présente invention prévoit un commutateur S2 qui, dans la phase inactive, relie l'entrée non-inverseuse de l'amplificateur de transconductance 16 à la tension de référence Vref et l'entrée inverseuse à la sortie de l'amplificateur suiveur 18. Pendant la phase active, ce commutateur S2 établit les connexions de la figure 2.

La figure 4 représente, dans l'exemple d'un magnétophone, les allures des signaux de commande des commutateurs S1 et S2 en fonction d'un signal PB/REC de sélection de mode du circuit de traitement et d'un signal MUTE utilisé classiquement dans un magnétophone pour atténuer des effets parasites lors des commutations de mode et lors de la mise sous tension. Le signal MUTE agit, par exemple en forçant à zéro les sorties d'amplificateurs qui produiraient des impulsions parasites.

A un instant t₀, le circuit est mis sous tension. Le signal MUTE est actif pour effectuer une atténuation des effets parasites liés à la mise sous tension. Le signal PB/REC est à 1 et sélectionne le mode actif du circuit. Les signaux de commande S1 et S2 des commutateurs S1 et S2 sont à 1 ; les commutateurs S1 et S2 sont dans les positions représentées à la figure 3.

A un instant t₁, le signal MUTE commute à 0 et le circuit fonctionne normalement en mode actif.

A un instant t₂, le circuit de traitement est mis dans son mode inactif par le passage à 0 du signal PB/REC. Le signal MUTE est activé pour atténuer les effets parasites liés à la commutation. Le commutateur S2 est basculé mais le commutateur S1 n'est pas encore actionné. L'amplificateur de transconductance 16, recevant la tension de référence Vref et la tension Vc sur la borne A de la capacité CI, fournit un courant à la capacité CI de manière que celle-ci se charge à la tension Vref.

A un instant t₃, le signal MUTE est désactivé. La capacité CI a eu le temps de se charger à la valeur Vref. Le commutateur S2 est remis à sa position initiale. Le commutateur S1 est basculé pour relier la capacité CI au pont de résistances R3, R4. A cet instant, les tensions aux bornes de la capacité CI et en sortie du pont R3 et R4 sont les mêmes et il ne se produit aucune impulsion parasite.

A un instant t₄, le signal PB/REC passe à 1 pour choisir le mode actif du circuit. Le commutateur S1 retrouve sa position initiale et le signal MUTE est activé jusqu'à un instant t₅ pour atténuer les effets parasites liés à la commutation.

Selon une variante, comme cela est représenté à la figure 3, l'amplificateur de transconductance 16 reçoit un signal G permettant de sélectionner une transconductance basse ou une transconductance élevée. On choisit la transconductance basse en régime établi afin d'obtenir une constante de temps élevée pour charger la capacité CI, ceci pour que la boucle de compensation de décalage ne suive pas les oscillations à la fréquence la plus basse du signal à traiter. Par contre, la transconductance élevée est choisie lorsqu'il faut rapidement charger ou décharger la capacité CI lors des transitions de mode du circuit de traitement.

A la figure 4 est également représentée l'allure du signal G, qui est celle du signal MUTE. A l'instant t₂, lorsque l'on passe du mode actif au mode inactif, le signal G est activé pour choisir la transconductanoe élevée jusqu'à l'instant t₃. Dans ce cas, la tension aux bornes de la capacité CI atteint rapidement la tension Vref, avant l'instant t₃ où le signal MUTE est désactivé.

De même, à l'instant t₄, lorsque le circuit passe du mode inactif au mode actif, le signal G est de nouveau activé jusqu'à l'instant t₅ pour que la tension aux bornes de la capacité CI atteigne rapidement la tension de correction Vc.

Comme cela est représenté entre les instants t₀ et t₁ (G=1), la transconductance élevée est également choisie à la mise sous tension du circuit.

La figure 5 illustre un exemple de circuit permettant d'obtenir les signaux S1, S2 et G à partir des signaux PB/REC et MUTE classiquement disponibles dans un magnétophone.

Le signal G correspond directement au signal MUTE.

Le signal S1 est fourni par une porte OU 25 recevant les signaux PB/REC et MUTE.

Le signal S2 est fourni par une porte NON-ET 26 recevant l'inverse du signal PB/REC et le signal MUTE.

## Revendications

1. Circuit de traitement de signal comprenant un amplificateur différentiel (10) recevant sur une première entrée un signal à traiter (Vin) et sur une deuxième entrée un signal de compensation de décalage (Vc) fourni par un intégrateur (14) de la différence entre la tension de sortie (Vout) du circuit et une tension de référence (Vref) sur laquelle on souhaite centrer le signal de sortie, caractérisé en ce que l'intégrateur comprend :
- un amplificateur de transconductanoe différentiel (16) reoevant la tension de sortie (Vout) sur une première entrée et la tension de référence (Vref) sur une deuxième entrée ;
- une capacité (CI) dont une première borne (A) est reliée à la sortie de l'amplificateur de transconductance et une deuxième borne reliée à une tension fixe (V-) ; et
- un amplificateur suiveur (18) recevant la tension sur la première borne de la capacité et fournissant le signal de compensation de décalage (Vc).

2. Circuit de traitement de signal selon la revendication 1, caractérisé en ce que sa sortie (Vout) est prise en compte pendant une phase active et ignorée pendant une phase inactive, et en ce qu'il comprend un premier commutateur (S1) commandé pour, dans la phase active, relier la première borne (A) de la capacité (CI) à la sortie de l'amplificateur de transconductanoe (16) et pour, dans la phase inactive, relier la première borne de la capacité à la sortie d'un générateur (R3, R4) de la tension de référence (Vref).

3. Circuit de traitement de signal selon la revendication 2, caractérisé en ce qu'il comprend un deuxième commutateur (S2) pour, dans la phase active, relier les première et deuxième entrées de l'amplificateur de transconductance (16) au signal de sortie (Vout) et à la tension de référence (Vref), respectivement, et pour, au début de la phase inactive, relier les première et deuxième entrées de l'amplificateur de transconductance à la tension de référence et à la sortie de l'amplificateur suiveur respectivement, la commande du premier commutateur (S1) étant retardée.

4. Circuit de traitement de signal selon la revendication 3, caractérisé en ce que l'amplificateur de transconductanoe (16) a deux transconductances sélectionnables par un signal de commande (G) qui prend des états tels que la transconductance la plus élevée est sélectionnée au début de chaque transition de mode du circuit de traitement.

## Patentansprüche

1. Signalbe- bzw. -verarbeitungsschaltung mit einem Differenzverstärker (10), dem an einem ersten Eingang das zu be- bzw. verarbeitende Signal (Vin) und an einem zweiten Eingang ein Signal (Vc) zur Versetzungskompensation zugeführt wird, das von einem Integrator (14) gebildet wird, welcher die Differenz zwischen der Ausgangsspannung (Vout) der Schaltung und einer Bezugsspannung (Vref), bezüglich welcher das Ausgangssignal zentriert werden soll, integriert,
dadurch gekennzeichnet, daß der Integrator aufweist:
- einen verstärker (16) mit differenzieller bzw. unterschiedlicher Steilheit, wobei dem Verstärker an einem ersten Eingang die Ausgangsspannung (Vout) und an einem zweiten Eingang die Bezugsspannung (Vref) zugeführt werden;
- einen Kondensator (CI), dessen erster Anschluß (A) mit dem Ausgang des Steilheits-Verstärkers und dessen zweiter Anschluß mit einer festen Spannung (V-) verbunden sind; sowie
- einen Folge-Verstärker (18), dem die Spannung am ersten Anschluß des Kondensators zugeführt wird und der das Versetzungs-Kompensationssignal (Vc) liefert.

2. Signalbearbeitungsschaltung nach Anspruch 1, dadurch gekennzeichnet, daß ihre Ausgangsgröße (Vout) während einer aktiven Phase in Betracht gezogen und benutzt wird und während einer inaktiven Phase ignoriert und nicht benutzt wird, und daß die Schaltung einen ersten Schalter (S1) aufweist, der so gesteuert wird, daß er in der aktiven Phase den ersten Anschluß (A) des Kondensators (CI) mit dem Ausgang des Steilheits-Verstärkers (16) verbindet und in der inaktiven Phase den ersten Anschluß des Kondensators mit dem Ausgang eines Generators (R3, R4) für die Bezugsspannung (Vref) verbindet.

3. Signalbearbeitungsschaltung nach Anspruch 2, dadurch gekennzeichnet, daß die Schaltung einen zweiten Schalter (S2) aufweist, der in der aktiven Phase den ersten bzw. den zweiten Eingang des Steilheits-Verstärkers (16) mit dem Ausgangssignal (Vout) bzw. mit der Bezugsspannung (Vref) verbindet und zu Beginn der inaktiven Phase den ersten bzw. den zweiten Eingang des Steilheits-Verstärkers mit der Bezugsspannung bzw. mit dem Ausgang des Folge-Verstärkers verbindet, wobei die Umschaltung des ersten Schalters (S1) verzögert ist.

4. Signalbearbeitungsschaltung nach Anspruch 3, dadurch gekennzeichnet, daß der Steilheits-Verstärker (16) zwei durch ein Steuersignal (G) wählbare Steilheiten besitzt, wobei das Steuersignal solche Zustände annimmt, daß die höchste Steilheit zu Beginn jedes Mode-Übergangs der Bearbeitungsschaltung gewählt wird.

## Claims

1. A signal processing circuit including a differential amplifier (10) receiving at a first input a signal to process (Vin) and at a second input an offset compensation signal (Vc) provided by an integrator (14) integrating the difference between the output voltage (Vout) of the circuit and a reference voltage (Vref) on which it is desired to center the output voltage, characterized in that the integrator includes:
- a differential transconductance amplifier (16) receiving an output voltage (Vout) of the circuit at a first input and a reference voltage (Vref) at a second input;
- a capacitor (CI) having a first terminal (A) connected to the output of the transconductance amplifier and a second terminal connected to a fixed voltage (V-); and
- a voltage follower (18) receiving the voltage at the first terminal of the capacitor and providing the offset compensation signal (Vc).

2. The signal processing circuit of claim 1, whose output (Vout) is taken into account during an active phase and ignored during an inactive phase, including a first switch (S1) for connecting the first terminal (A) of the capacitor (CI) to the output of the transconductance amplifier (16) during the active phase, and for connecting the first terminal of the capacitor to the output of a generator (R3, R4) of the reference voltage (Vref), during the inactive phase.

3. The signal processing circuit of claim 2, including a second switch (S2) for connecting the first and second inputs of the transconductance amplifier (16) to the output signal (Vout) and to the reference voltage (Vref), respectively, during the active phase, and for connecting the first and second inputs of the transconductance amplifier to the reference voltage and to the output of the voltage follower, respectively, at the beginning of the inactive phase, the switching of said first switch (S1) being delayed.

4. The signal processing circuit of claim 3, wherein the transconductance amplifier (16) has two transconductances that can be selected by a control signal (G) taking states such that the highest transconductance is selected at the beginning of each mode transition of the processing circuit.
